# EUROPEAN PATENT SPECIFICATION

(11) **EP 3 199 339 B1**
(45) Date of publication and mention of the grant of the patent: **31.05.2023**
(21) Application number: 17153236.9
(22) Date of filing: 26.01.2017
(51) Int. Cl.: B32B 7/12, G06F 1/16, B32B 27/08

(54) **TRANSPARENT PROTECTIVE LAYER AND ELECTRONIC DEVICE INCLUDING SAME**
TRANSPARENTE SCHUTZFOLIE UND ELEKTRONISCHE VORRICHTUNG DAMIT
COUCHE DE PROTECTION TRANSPARENTE ET DISPOSITIF ÉLECTRONIQUE LA COMPRENANT

(30) Priority: 28.01.2016 KR 20160010924; 01.06.2016 KR 20160068040
(43) Date of publication of application: 02.08.2017
(73) Proprietor: Samsung Electronics Co., Ltd., Gyeonggi-do 16677 (KR)
(72) Inventor: Kim, Young-Gyun, Suwon-si (KR); Kim, Minjung, Seongnam-si (KR); Oh, Jeeyoung, Suwon-si (KR)
(74) Representative: Nederlandsch Octrooibureau

(56) References cited:
- WO-A2-2012/092342
- US-A1- 2015 043 137
- US-A1- 2016 002 501

## Description

### BACKGROUND

### 1. Field of the Disclosure

The present disclosure relates generally to a transparent protective layer, and more particularly, to a transparent protective layer of an electronic device.

### 2. Description of Related Art

Various electronic devices, such as a smartphone, tablet personal computer (PC), or mobile phone, have a transparent protective layer to protect the electronic devices. Such a conventional transparent protective layer may form an outer surface of an electronic device and prevent a foreign substance from discoloring or penetrating the electronic device.

However, because the transparent protective layer is exposed to the outside, there is a high possibility of it being damaged, e.g., a scratch or breakage. This is more probable for a touch-screen smartphone that is touched many times by a user.

When the conventional transparent protective layer is damaged, it should be replaced. However, it is often difficult for a user to remove the conventional transparent protective layer from an electronic device. Further, adhesive from the damaged transparent protective layer often remains. Accordingly, replacing a conventional transparent protective layer is often difficult.

US 2016/002501 discloses a double sided adhesive film, an adhesive layer-equipped transparent plate, and a laminate, capable of improving reworkability.

US 2015/043137 discloses a protective window for a display device, the display device including a display unit, a first protective window, and second protective window unit. the second protective window unit includes a second protective window, an ink layer, a second protective window adhesive layer.

WO 2012/092342 discloses a double-sided adhesive tape, which is easily peeled off by force applied to an adhered surface in a parallel direction thereby providing excellent reworkability.

### SUMMARY

The present disclosure has been made to address at least the above-mentioned problems or disadvantages and to provide at least the advantages described below.

Accordingly, an aspect of the present disclosure is to provide a transparent protective layer having high surface hardness and scratch resistance, which can be easily replaced.

Embodiments of the present disclosure provide a transparent protective layer comprising a first transparent plate having a first surface facing in a first direction and a second surface facing in a second direction opposite to the first direction, a second transparent plate having a first surface facing in the first direction and a second surface facing in the second direction, and an adhesive layer disposed between the second surface of the first transparent plate and the first surface of the second transparent plate, wherein the adhesive layer includes a first adhesive layer having a first adhesive force between the first adhesive layer and the first transparent plate, and a second adhesive layer having a second adhesive force between the second adhesive layer and the second transparent plate, which is less than the first adhesive force, and a third transparent plate disposed between the first adhesive layer and the second adhesive layer, wherein the third transparent plate comprises an opening formed therein, wherein the opening is disposed at a position corresponding to a camera.

### BRIEF DESCRIPTION OF THE DRAWINGS

The above and other aspects, features, and advantages of certain embodiments of the present disclosure will be more apparent from the following detailed description taken in conjunction with the accompanying drawings, in which:
FIG. 1 illustrates a transparent protective layer according to an embodiment of the present disclosure;
FIG. 2 is an exploded view of the transparent protective layer illustrated in FIG. 1;
FIG. 3 is a cross-sectional view of the transparent protective layer taken along line I - I' in FIG. 1;
FIGs. 4A and 4B are cross-sectional views of transparent protective layers according to various embodiments of the present disclosure;
FIGs. 5A and 5B are cross-sectional views of transparent protective layers according to various embodiments of the present disclosure;
FIG. 6 illustrates a transparent protective layer according to an embodiment of the present disclosure;
FIG. 7 is a cross-sectional view of the transparent protective layer taken along line II - II' in FIG. 6;
FIG. 8 illustrates an electronic device including a transparent protective layer according to an embodiment of the present disclosure;
FIG. 9 is an exploded perspective view of the electronic device illustrated in FIG. 8;
FIGs. 10A and 10B are cross-sectional views taken along line III - III' in FIG. 9 according to various embodiments of the present disclosure;
FIG. 11 illustrates an electronic device according to an embodiment of the present disclosure;
FIG. 12 is a cross-sectional view of the electronic device taken along line IV - IV' in FIG. 11;
FIG. 13 illustrates an electronic device according to an embodiment of the present disclosure; and
FIG. 14 is a cross-sectional view of the electronic device taken along line V - V' in FIG. 13.

### DETAILED DESCRIPTION

Hereinafter, various embodiments of the present disclosure will be described with reference to the accompanying drawings. However, it should be understood that there is no intent to limit the present disclosure to the particular forms disclosed herein. Instead, the present disclosure should be construed to cover various modifications, equivalents, and/or alternatives of the described embodiments.

In describing the drawings, similar reference numerals may be used to designate similar constituent elements.

The terms and expressions used in the present disclosure are only used to describe specific embodiments, and are not intended to limit the present disclosure. As used herein, singular forms may include plural forms as well unless the context clearly indicates otherwise. Unless defined otherwise, all terms and expressions used herein, including technical terms and scientific terms, may have the same meaning as commonly understood by a person of ordinary skill in the art to which the present disclosure pertains. Terms and expressions, such as those defined in commonly used dictionaries, should be interpreted as having meanings that are consistent with their meanings in the context of the relevant art and should not be interpreted in idealized or overly formal senses, unless expressly so defined herein. In some cases, even a term defined in the present disclosure should not be interpreted to exclude embodiments of the present disclosure.

Herein, the expressions "have", "may have", "include", or "may include" refer to the existence of a corresponding feature (e.g., numeral, function, operation, or constituent element such as component), and do not exclude one or more additional features.

The expressions "A or B", "at least one of A and/or B", or "one or more of A and/or B" may include any or all possible combinations of items enumerated together. For example, "A or B," "at least one of A and B," or "at least one of A or B" may refer to (1) at least one A, (2) at least one B, or (3) both at least one A and at least one B.

The expressions "a first", "a second", "the first", or "the second" may modify various components, regardless of the order and/or the importance, but do not limit the corresponding components. The above-described expressions may be used to distinguish an element from another element. For example, a first user device and a second user device indicate different user devices although both of them are user devices. For example, a first element may be referred to as a second element, and similarly, a second element may be referred to as a first element, without departing from the scope of the present disclosure.

When an element (e.g., a first element) is referred to as being (operatively or communicatively) "connected," or "coupled," to another element (e.g., a second element), the first element may be directly connected or coupled directly to the second element or another element (e.g., a third element) may be interposed therebetween. However, when the first element is referred to as being "directly connected," or "directly coupled" to the second element, there are no intervening elements therebetween.

The expression "configured to" used in the present disclosure may be interchangeably used with, for example, "suitable for", "having the capacity to", "designed to", "adapted to", "made to", or "capable of" according to context. The expression "configured to" may not necessarily mean "specially designed to" in terms of hardware. In some situations, the expression "device configured to" may mean that the device, together with other devices or components, "is able to". For example, "a processor adapted (or configured) to perform A, B, and C" may indicate a dedicated processor (e.g. an embedded processor) for performing the corresponding operations or a generic-purpose processor (e.g., a central processing unit (CPU) or an application processor (AP)) that can perform the corresponding operations by executing one or more software programs stored in a memory device.

In the transparent protective layer and the electronic device above, the first transparent plate can be easily separated from the second transparent plate through the adhesive layer. When separating the first transparent plate, an adhesive material does not remain on the second transparent plate, so that the first transparent plate can be separated without stickiness. That is, when replacement of the first transparent plate is required, the first transparent plate can be cleanly separated from the second transparent plate, thereby preventing a foreign substance from adhering to the second transparent plate while the first transparent plate is separated and replaced. Accordingly, the reassembly of the transparent protective layer can be secured.

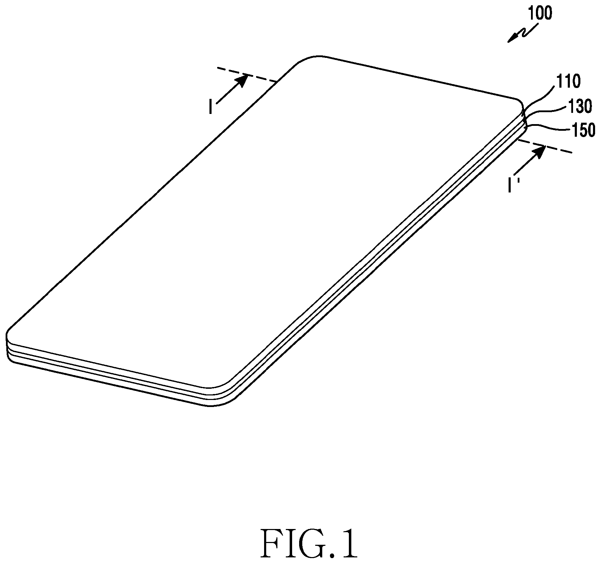

FIG. 1 illustrates a transparent protective layer according to an embodiment of the present disclosure.

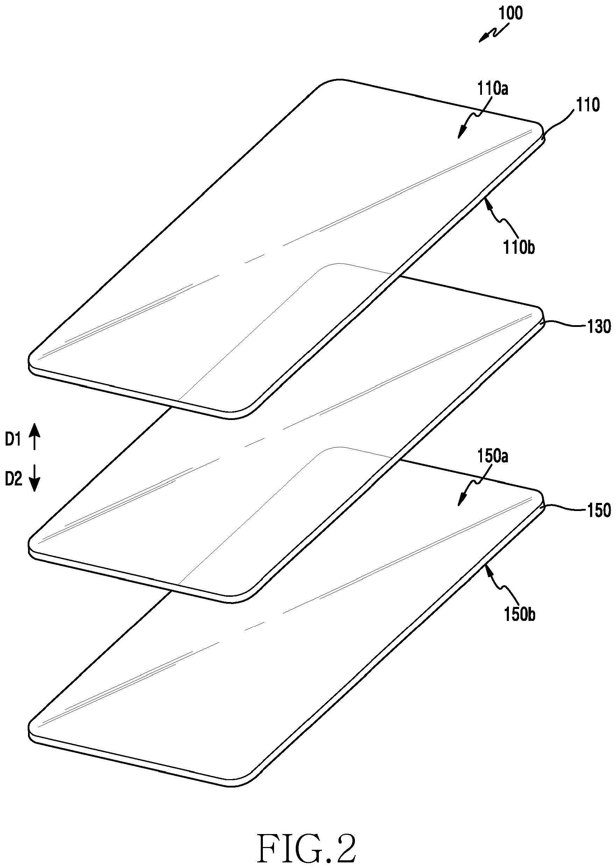

FIG. 2 is an exploded view of the transparent protective layer illustrated in FIG. 1.

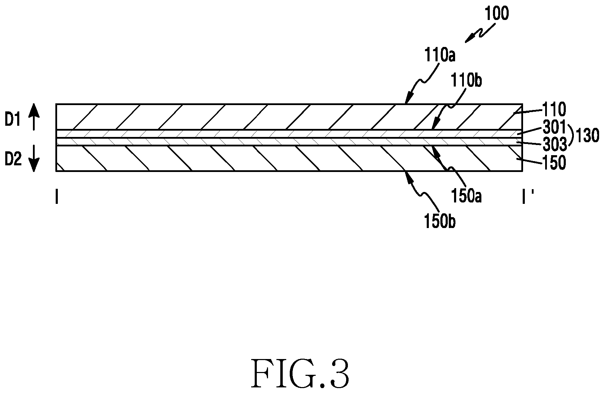

FIG. 3 is a cross-sectional view of the transparent protective layer taken along line I - I' in FIG. 1.

Referring to FIGs. 1 to 3, a transparent protective layer 100 includes a first transparent plate 110, an adhesive layer 130, and a second transparent plate 150. The transparent protective layer 100 may be provided on various electronic devices including a display, such as a smartphone, a tablet personal computer, a mobile phone, etc. The transparent protective layer 100 may be provided on an outer surface (a front surface and/or a back surface) of various electronic devices. The transparent protective layer 100 may protect various electronic devices.

The first transparent plate 110 includes a first surface 110a and a second surface 110b. The first surface 110a may faces a first direction D1 in the first transparent plate 110. The second surface 110b faces a second direction D2 in the first transparent plate 110.

The first transparent plate 110 may include a high hardness sheet including a polymeric material. For example, the first transparent plate 110 may be formed of at least one of polycarbonate (PC), polymethyl methacrylate (PMMA), polyimide (PE), polyethylene terephthalate (PET), polypropylene terephthalate (PPT), amorphous polyethylene terephthalate (APET), polyethylene naphthalate terephthalate (PEN), polyethylene terephthalate glycol (PETG), tri-acetyl cellulose (TAC), cyclic olefin polymer (COP), cyclic olefin copolymer (COC), polydicyclopentadiene (DCPD), cyclopentadiene anions (CPD), polyarylate (PAR), polyether sulfone (PES), polyether imide (PEI), modified epoxy resin, and acrylic resin.

For example, the first transparent plate 110 may be 1) a lamination of a PC sheet and a PMMA sheet, 2) a PMMA sheet that is a single layer, 3) an optical PC sheet,4) a copolymer of PMMA and particular PMMA, 5) a PEI sheet, 6) a copolymer of PC and PEI, or 7) a copolymer of PMMA and PEI.

Additionally, the first transparent plate 110 may include glass. When the first transparent plate 110 includes glass, high surface hardness can be secured so that a good bodily sensation quality can be provided to a user. Further, a high Young's modulus is secured so that a display defect due to a local impact can be prevented to prevent the occurrence of a defective pixel, such as a bright spot. While using glass may be problematic in that glass may be broken, the first transparent plate 110 can be easily replaced due to the adhesive layer 130, which will be described in more detail below.

The first transparent plate 110 may have a first hardness, which may be high hardness of pencil hardness 3 H or greater. The second transparent plate 150 may have a second hardness, which is less than the first hardness. However, the present disclosure is not limited thereto, and both the first transparent plate 110 and the second transparent plate 150 may have high hardness.

Using the first transparent plate 110, high surface hardness and scratch resistance of the transparent protective layer 100 can be secured. Further, the first transparent plate 110 can prevent a foreign substance from discoloring or penetrating the transparent protective layer 100.

The adhesive layer 130 may be disposed or formed on the second surface 110b of the first transparent plate 110. The adhesive layer 130 may be disposed or formed on a first surface 150a of the second transparent plate 150. The adhesive layer 130 may be formed or disposed on the first surface 150a of the second transparent plate 150. The adhesive layer 130 may have a thickness of 0.02 mm to 0.2 mm.

The first transparent plate 110, the adhesive layer 130, and the second transparent plate 150 may be sequentially arranged in the second direction D2.

An adhesive force between the first surface 150a of the second transparent plate 150 and the adhesive layer 130 may be less than an adhesive force between the second surface 110b of the first transparent plate 110 and the adhesive layer 130. Therefore, when a force is applied to separate the first transparent plate 110 from the second transparent plate 150, the first transparent plate 110 can be easily separated from the second transparent plate 150 while maintaining adhesion of the adhesive layer 130 to the first transparent plate 110 and.

More specifically, as illustrated in FIG. 3, the adhesive layer 130 includes a first adhesive layer 301 and a second adhesive layer 303. The first adhesive layer 301 and the second adhesive layer 303 may be sequentially arranged in the second direction D2. The first adhesive layer 301 may be disposed or formed on the second surface 110b of the first transparent plate 110. The second adhesive layer 303 may be disposed or formed on the first surface 150a of the second transparent plate 150. An adhesive force between the second adhesive layer 303 and the second transparent plate 150 may be less than an adhesive force between the first adhesive layer 301 and the second adhesive layer 303. Further, the adhesive force between the second adhesive layer 303 and the second transparent plate 150 may be less than an adhesive force between the first adhesive layer 301 and the first transparent plate 110. Therefore, when a force is applied to separate the first transparent plate 110 from the second transparent plate 150, the first transparent plate 110 can be easily separated from the second transparent plate 150 while maintaining adhesion of the first transparent plate 110, the first adhesive layer 301, and the second adhesive layer 303.

For example, the first adhesive layer 301 may have a first adhesive force of 500 g/in(gram per inch) to 2000 g/in. When the first adhesive force is less than 500 g/in, it may be difficult to achieve a minimal adhesion between the first transparent plate 110 and the first adhesive layer 301. Further, it may be difficult to implement the first adhesive layer 301 having the first adhesive force exceeding 2000g/in.

The first adhesive force may be changed depending on the kind of a substance contained in the first transparent plate 110 and/or the first adhesive layer 301. For example, the first adhesive layer 301 may include acrylic resin, optically clear adhesive (OCA), or optically clear resin (OCR). Alternatively, the first adhesive layer 301 may be formed by laminating an OCA film on the first transparent plate 110 or by bonding or coating OCR on the first transparent plate 110.

The first adhesive layer 301 may include urethane resin. The first adhesive layer 301 may be formed by coating the second surface 110b of the first transparent plate 110 with urethane resin. For example, the first adhesive layer 301 may be formed by curing a coating liquid by irradiating ultraviolet (UV) light onto a urethane acrylate-based coating liquid. That is, the first adhesive layer 301 may be a urethane coating layer. Alternatively, the first adhesive layer 301 may be a polyurethane film. The first adhesive layer 301 may be formed by laminating a polyurethane film on the first transparent plate 110.

The second adhesive layer 303 may have a second adhesive force of 50 g/in to 300 g/in. When the second adhesive force is less than 50 g/in, it may be difficult to achieve a minimal adhesion between the second transparent plate 150 and the second adhesive layer 303. When the second adhesive force exceeds 300 g/in, separating between the second transparent plate 150 and the second adhesive layer 303 may be difficult. The second adhesive force may have a value of 50 g/in to 300 g/in so that the second adhesive layer 303 can be easily separated from the second transparent plate 150, e.g., when the first transparent plate 110 is broken and should be replaced.

The second adhesive force may be changed depending on the kind of substance of the second transparent plate 150 and/or the second adhesive layer 303. For example, a second adhesive force used when the second adhesive layer 303 includes a pressure sensitive adhesive (PSA) and the second transparent plate 150 includes PC may be different from a second adhesive force used when the second transparent plate 150 includes glass. For example, when the second transparent plate 150 includes PC, the second adhesive force may be about 180 g/in, and when the second transparent plate 150 includes glass, the second adhesive force may be about 70 g/in. That is, the second adhesive force when the second transparent plate 150 includes PC may be two or more times greater than the second adhesive force when the second transparent plate 150 includes glass.

The second adhesive layer 303 may include silicone resin. For example, the second adhesive layer 303 may be a PSA. The second adhesive layer 303 may be formed by laminating a PSA film on the second transparent plate 150. Alternatively, the second adhesive layer 303 may be formed by laminating a PSA film on the first adhesive layer 301. When the second adhesive layer 303 is a PSA film, the second adhesive layer 303 may be adhered merely using pressure, without requiring a separate heat treatment or UV treatment at normal temperature.

The second adhesive layer 303 may include fluorine (F). The second adhesive layer 303 may be formed by coating the first surface 150a of the second transparent plate 150 with F. Alternatively, the second adhesive layer 303 may be formed by coating F on the first adhesive layer 301. For example, the second adhesive layer 303 may be formed by coating a coating liquid containing F in various ways. That is, the second adhesive layer 303 may be an F coating layer.

The first adhesive layer 301 may include acrylic resin, e.g., OCA or OCR. The second adhesive layer 303 may include silicone resin, e.g., PSA.

The first adhesive layer 301 may include a urethane coating layer, e.g., a polyurethane film, and the second adhesive layer 303 may include a PSA film.

The first adhesive layer 301 may include acrylic resin, e.g., OCA, and the second adhesive layer 303 may include an F coating layer.

The second transparent plate 150 includes a first surface 150a and a second surface 150b. The first surface 150a faces the first direction D1 and the second surface 150b faces the second direction D2.

The second transparent plate 150 may include an impact resistant sheet or an optical sheet containing a polymer organic material.

For example, the second transparent plate 150 may be formed of at least one of PC, PMMA, PE, PET, PPT, APET, PEN, PETG, TAC, COP, COC, DCPD, CPD, PAR, PES, PEI, glass, modified epoxy resin, and acrylic resin.

The second transparent plate 150 may include a PC sheet. The second transparent plate 150 may be a single layer of a PC sheet.

The second transparent plate 150 may have a double-sided coating or a single-sided coating to improve scratches and the like during processing. When the second transparent plate 150 has a single-sided coating, it is possible to increase an adhesive force between the second transparent plate 150 and various configurations arranged under the second transparent plate 150. Alternatively, when the second transparent plate 150 has a double-sided coating, the bending feature of the transparent protective layer 100 can be improved.

Alternatively, the second transparent plate 150 may include tempered glass. When the second transparent plate 150 includes glass, a high Young's modulus is secured so that a display defect, such as a bright spot, a dim spot, or a leakage of light, due to a local impact, can be prevented.

The first transparent plate 110 may have a first impact strength, and the second transparent plate 150 may have a second impact strength greater than the first impact strength. The second impact strength may be 700 J/m or greater. However, the present disclosure is not limited thereto, and both the first transparent plate 110 and the second transparent plate 150 may have high impact strengths.

Accordingly, the transparent protective layer 100 illustrated in FIGs. 1-3 is resistant against damage by a partial impact, a drop impact, etc., through the second transparent plate 150.

In addition, the first transparent plate 110 may have a first Young's modulus, and the second transparent plate 150 may have a second Young's modulus, which is greater than the first Young's modulus. The second Young's modulus may be 66 GPa or greater. Accordingly, the transparent protective layer 100 illustrated in FIGs. 1-3 is resistant against a display defect due to a local impact through the second transparent plate 150, thereby preventing the occurrence of a defective pixel, such as a bright spot, a dim spot, or a leakage of light. However, the present disclosure is not limited thereto, and both the first transparent plate 110 and the second transparent plate 150 may have high Young's moduli.

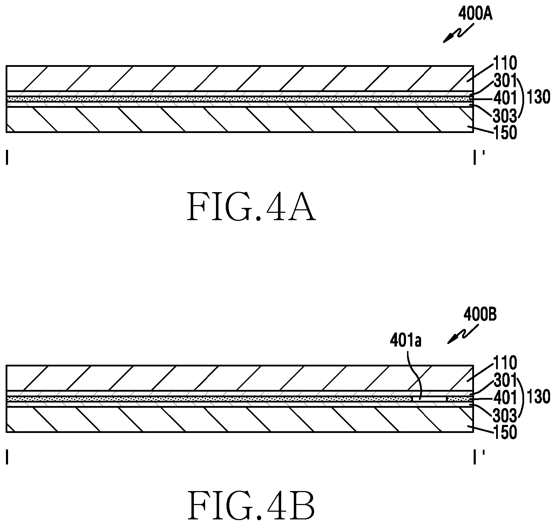

FIGs. 4A and 4B are cross-sectional views of transparent protective layers according to various embodiments of the present disclosure. Specifically, the transparent protective layers 400A and 400B illustrated in FIGs. 4A and 4B, respectively, have the same configurations as the transparent protective layer 100 described above, except that the transparent protective layer 400A includes a third transparent plate 401, and the transparent protective layer 400B includes the third transparent plate 401 and a first opening 401a formed therein.

Referring to FIG. 4A, the adhesive layer 130 includes the first adhesive layer 301, the third transparent plate 401, and the second adhesive layer 303. That is, the transparent protective layer 400A further includes the third transparent plate 401 between the first adhesive layer 301 and the second adhesive layer 303.

A laminating process of the first transparent plate 110, the adhesive layer 130, and the second transparent plate 150 may be easily performed through the third transparent plate 401. That is, the adhesive layer 130 may be prepared by forming the first adhesive layer 301 and the second adhesive layer 303 on opposite sides of the third transparent plate 401, and then the transparent protective layer 400A may be produced through a laminating process of the adhesive layer 130 and the first transparent plate 110 and/or the second transparent plate 150. An adhesive force between the first transparent plate 110, the first adhesive layer 301, the third transparent plate 401, and the second adhesive layer 303 may be greater than an adhesive force between the second adhesive layer 303 and the second transparent plate 150. Therefore, the first transparent plate 110, the first adhesive layer 301, the third transparent plate 401, and the second adhesive layer 303 can be easily separated from the second transparent plate 150, while maintaining adhesion of the first transparent plate 110, the first adhesive layer 301, the third transparent plate 401, and the second adhesive layer 303.

The third transparent plate 401 may be made of a transparent material having a high transmittance. The third transparent plate 401 may be made of a material that allows thin-film forming. The third transparent plate 401 may include an isotropic film, e.g., a COP film, a casting polypropylene (CPP) film. The isotropic film may be produced by a non-stretching process or an unstretching process. That is, the third transparent plate 401 may include a non-stretched or unstretched film. A film produced by a non-stretching or unstretching process may have similar tensile strengths in a longitudinal direction and in a transverse direction. Alternatively, tensile elongation in the longitudinal direction and the transverse direction may have similar values to each other. For example, the CPP film may have tensile strength of 80±30 MPa in the longitudinal direction and tensile strength of 60±20 MPa in the transverse direction. In addition, the CPP film may have tensile elongation of 650±300% in the longitudinal direction and 850±300% in the transverse direction. The third transparent plate 401 may include the isotropic film, so that retardation of light that is transmitted through the third transparent plate 401 can be reduced. For example, light that is transmitted through the third transparent plate 401 may have retardation of 10 nm or less. Therefore, the distortion of light can be prevented through the adhesive layer 130 including the isotropic film.

Alternatively, the third transparent plate 401 may include an anisotropic film. The third transparent plate 401 may be, e.g., a PET film or a polypropylene (PP) film. The anisotropic film may be a film produced by a stretching process.

Referring to FIG. 4B, the third transparent plate 401 includes the first opening 401a formed therein. The first opening 401a is disposed at a position corresponding to a camera. Therefore, even if the third transparent plate 401 includes the anisotropic film, the distortion of light that is transmitted through the adhesive layer 130 does not occur through the first opening 401a, in order to secure the optical performance of the camera. However, the third transparent plate 401 including an isotropic film may also include the first opening 401a.

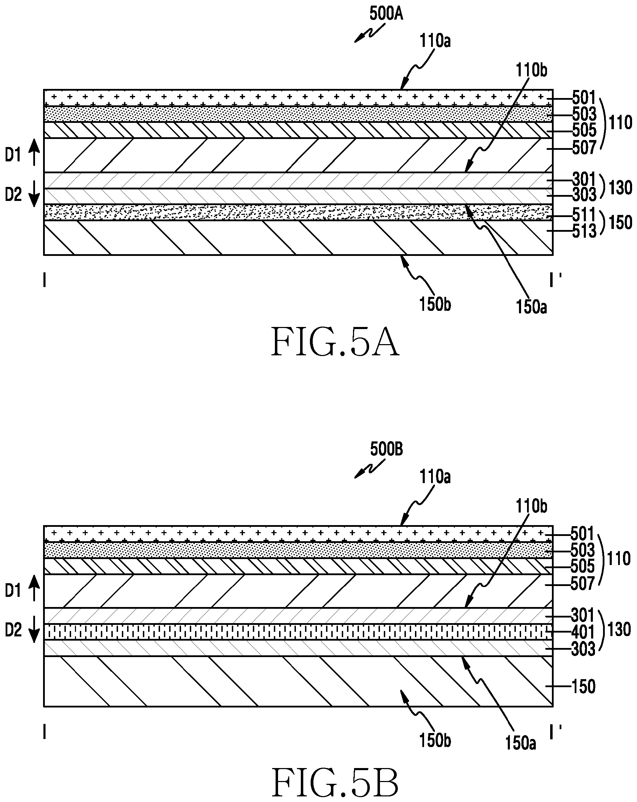

FIGs. 5A and 5B are cross-sectional views of transparent protective layers according to various embodiments of the present disclosure.

Referring to FIG 5A, a transparent protective layer 500A includes a first transparent plate 110, an adhesive layer 130, and a second transparent plate 150. Specifically, the transparent protective layer 500A illustrated in FIG. 5A has the same configuration as the transparent protective layer 100 described above, except that the first transparent plate 110 of FIG. 5A includes a first layer 501, a second layer 503, a third layer 505, and a fourth layer 507, and the second transparent plate 150 of FIG. 5A includes a fifth layer 511 and a sixth layer 513.

The first layer 501 forms a first surface 110a of the first transparent plate 110. The first layer 501 may include F. The first layer 501 may be an F coating layer. The first layer 501 may be an anti-fingerprint (AF) coating layer, which prevents the surface of the transparent protective layer 500A from being contaminated by a fingerprint or various contaminants. That is, using the first layer 501, the fingerprint and contamination resistance of the transparent protective layer 500A can be improved. Further, using the first layer 501, the water-repellent function of the transparent protective layer 500A can be ensured.

The second layer 503 is disposed under the first layer 501in the second direction D2. The second layer 503 may be a hard coating layer. The second layer 503 may have a pencil hardness of 4 H or greater. Using the second layer 503, the surface strength and durability of the first transparent plate 110 can be improved. Further, using the second layer 503, the light transmittance of the first transparent plate 110 can be improved.

The third layer 505 and the fourth layer 507 are disposed under the second layer 503 in the second direction D2. The third layer 505 and the fourth layer 507 may be high hardness sheets containing a polymer material. For example, the third layer 505 may be a PMMA sheet and the fourth layer 507 may be a PC sheet. Alternatively, one layer may be provided instead of the third layer 505 and the fourth layer 507. For example, a PMMA sheet, an optical PC sheet, or a PI sheet, which is a single layer, may be provided instead of the third layer 505 and the fourth layer 507.

Alternatively, a single layer may be provided instead of the third layer 505 and the fourth layer 507, and the single layer may include a copolymer of PC and PI, a copolymer of PMMA and PI, or glass.

The surface hardness is improved by using the third layer 505 and the fourth layer 507, so that the occurrence of scratches due to external factors can be minimized.

The first adhesive layer 301 may be a urethane coating layer. The first adhesive layer 301 may be formed by coating a urethane coating liquid on the second surface 110b of the first transparent plate 110. The second adhesive layer 303 may be PSA. The second adhesive layer 303 may be formed by coating a PSA adhesive on the second surface 110b of the first transparent plate 110. Thereafter, the first transparent plate 110 and the second transparent plate 150 may be laminated. After the first transparent plate 110 and the second transparent plate 150 are laminated, an autoclave process may be further performed. An autoclave can expose the first transparent plate 110 and the second transparent plate 150 that are laminated in a high-temperature and high-pressure chamber for a certain time to remove air bubbles between adhesive surfaces, thereby improving an adhesive force.

The first adhesive layer 301 may be OCA. The second adhesive layer 303 may be an AF coating layer. The second adhesive layer 303 may be formed by coating an AF coating liquid on the first surface 150a of the second transparent plate 150. The first adhesive layer 301 may be formed by coating an OCA adhesive on the second adhesive layer 303. Thereafter, the first transparent plate 110 and the second transparent plate 150 may be laminated. After the first transparent plate 110 and the second transparent plate 150 are laminated, an autoclave process may be further performed.

The second transparent plate 150 includes the fifth layer 511 and the sixth layer 513. The fifth layer 511 may form the first surface 150a of the second transparent plate 150. The fifth layer 511 may be a hard coating layer. The fifth layer 511 may have a pencil hardness of 4 H or greater. The fifth layer 511 improves the surface strength and durability of the second transparent plate 150. Further, the fifth layer 511 improves the light transmittance of the second transparent plate 150.

The sixth layer 513 is disposed under the fifth layer 511 in the second direction D2. The sixth layer 513 may be an impact resistant sheet or an optical sheet containing a polymer organic material. For example, the sixth layer 513 may be a PC sheet. The sixth layer 513 improves the impact strength of the second transparent plate 150.

Referring to FIG. 5B, a transparent protective layer 500B includes the first transparent plate 110, the adhesive layer 130, and the second transparent plate 150. Specifically, the transparent protective layer 500B illustrated in FIG. 5B has the same configuration as the transparent protective layer 400A described above, except that the first transparent plate 110 of FIG. 5B includes the first layer 501, the second layer 503, the third layer 505, and the fourth layer 507.

The adhesive layer 130 includes a first adhesive layer 301, a third transparent plate 401, and a second adhesive layer 303.

As described above for FIG. 4A, a laminating process of the first transparent plate 110, the adhesive layer 130, and the second transparent plate 150 may be easily performed through the third transparent plate 401. That is, the adhesive layer 130 may be prepared by forming the first adhesive layer 301 and the second adhesive layer 303 on opposite sides of the third transparent plate 401, and then the transparent protective layer 400A may be produced through a laminating process of the adhesive layer 130 and the first transparent plate 110 and/or the second transparent plate 150. An adhesive force between the first transparent plate 110, the first adhesive layer 301, the third transparent plate 401, and the second adhesive layer 303 may be greater than an adhesive force between the second adhesive layer 303 and the second transparent plate 150. Accordingly, the first transparent plate 110, the first adhesive layer 301, the third transparent plate 401, and the second adhesive layer 303 can be easily separated from the second transparent plate 150, while maintaining adhesion of the first transparent plate 110, the first adhesive layer 301, the third transparent plate 401, and the second adhesive layer 303.

The third transparent plate 401 may be made of a transparent material having a high transmittance. The third transparent plate 401 may be made of a material that allows thin-film forming. The third transparent plate 401 may include an isotropic film, e.g., a COP film, a CPP film. The isotropic film may be produced by a non-stretching process or an unstretching process. That is, the third transparent plate 401 may include a non-stretched or unstretched film. A film produced by a non-stretching or unstretching process may have similar tensile strengths in a longitudinal direction and in a transverse direction. Alternatively, tensile elongation in the longitudinal direction and the transverse direction may have similar values to each other. For example, the CPP film may have tensile strength of 80±30 MPa in the longitudinal direction and tensile strength of 60±20 MPa in the transverse direction. In addition, the CPP film may have tensile elongation of 650±300% in the longitudinal direction and 850±300% in the transverse direction. The third transparent plate 401 may include the isotropic film, so that retardation of light that is transmitted through the third transparent plate 401 can be reduced. For example, light that is transmitted through the third transparent plate 401 may have retardation of 10 nm or less. Therefore, the distortion of light can be prevented through the adhesive layer 130 including the isotropic film.

Alternatively, the third transparent plate 401 may include an anisotropic film. The third transparent plate 401 may be, e.g., a PET film or a PP film. The anisotropic film may be a film produced by a stretching process.

The second transparent plate 150 may be a single layer and may include glass. Alternatively, the second transparent plate 150 may include tempered glass. When the single layer includes glass, the light transmittance can be improved. In addition, a high Young's modulus is secured so that a display defect due to a local impact can be prevented to prevent the occurrence of a defective pixel, such as a bright spot, a dim spot, or a leakage of light.

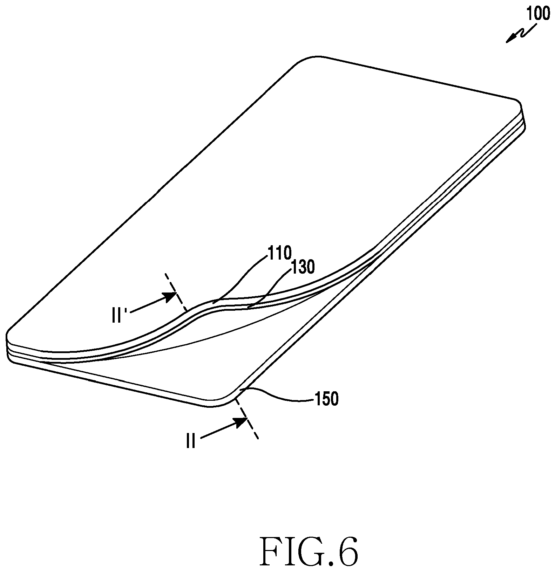

FIG. 6 illustrates a transparent protective layer according to an embodiment of the present disclosure.

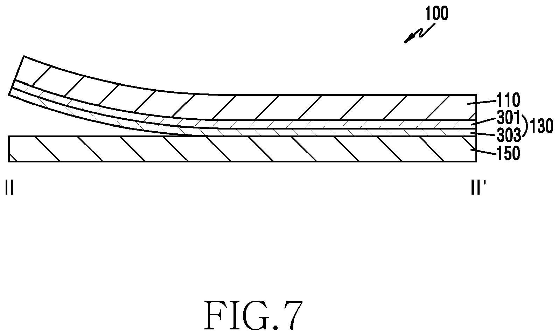

FIG. 7 is a cross-sectional view of the transparent protective layer taken along line II - II' in FIG. 6.

Specifically, FIGs. 6 and 7 illustrate the transparent protective layer 100 of FIGs. 1-3 being separated.

Referring to FIGs. 6 and 7, the adhesive layer 130 can be easily separated from the second transparent plate 150. That is, the adhesive layer 130 may be strongly adhered to the first transparent plate 110 through the first adhesive layer 301 having a strong adhesive force, and may be easily separated from the second transparent plate 150 through the second adhesive layer 303 having a weaker adhesive force. When the first transparent plate 110 is separated, the second adhesive layer 303 can be separated without leaving tacky portions on the second transparent plate 150. That is, when the first transparent plate 110 is to be replaced, the first transparent plate 110 can be neatly separated from the second transparent plate 150. This helps prevent a foreign substance from adhering to the second transparent plate 150 when the first transparent plate 110 is separated and replaced.

For the separation and replacement, a replacement transparent protective layer including only a first transparent plate 110 and an adhesive layer 130 may be produced or implemented. Here, production is not limited to industrial production and may include all activities, such as manufacturing, assembly, repairing, etc.

When an existing first transparent plate 110 is damaged and should be replaced, the first adhesive layer 301 and the second adhesive layer 303 can be easily separated from the second transparent plate 150 while maintaining adhesion of the first adhesive layer 301 and the second adhesive layer 303. The replacement transparent protective layer including a new first transparent plate and an adhesive layer may be attached to the existing second transparent plate 150.

As described above, in accordance with an embodiment of the present disclosure, a transparent protective layer may include a first transparent plate including a first surface and a second surface opposite to the first surface; and an adhesive layer disposed on the second surface of the first transparent plate. The adhesive layer may include a first adhesive layer having a first adhesive force; and a second adhesive layer having a second adhesive force less than the first adhesive force.

The adhesive layer further includes a third transparent plate disposed between the first adhesive layer and the second adhesive layer.

The third transparent plate may be an isotropic film.

The third transparent plate may include CPP.

The third transparent plate may include COP.

The third transparent plate may include an opening formed therein.

A first adhesive force may be 500 g/in to 2000 g/in, and a second adhesive force may be 50 g/in to 300 g/in.

The first adhesive layer may include at least one of acrylic resin, OCA, OCR, and urethane resin.

The second adhesive layer may include at least one of silicone resin, PSA, and F.

The transparent protective layer may further include a second transparent plate including a first surface and a second surface, the second transparent plate being placed on the adhesive layer, opposite the first transparent plate.

The first transparent plate may have a first Young's modulus and the second transparent plate may have a second Young's modulus, which is greater than the first Young's modulus.

The first transparent plate may have a first impact strength and the second transparent plate may have a second impact strength, which is greater than the first impact strength.

The first transparent plate may have a first hardness and the second transparent plate may have a second hardness, which is less than the first hardness.

The first transparent plate or the second transparent plate may include at least one of PC, PMMA, PE, PET, PPT, APET, PEN, PETG, TAC, COP, COC, DCPD, CPD, PAR, PES, PEI, glass, modified epoxy resin, and acrylic resin.

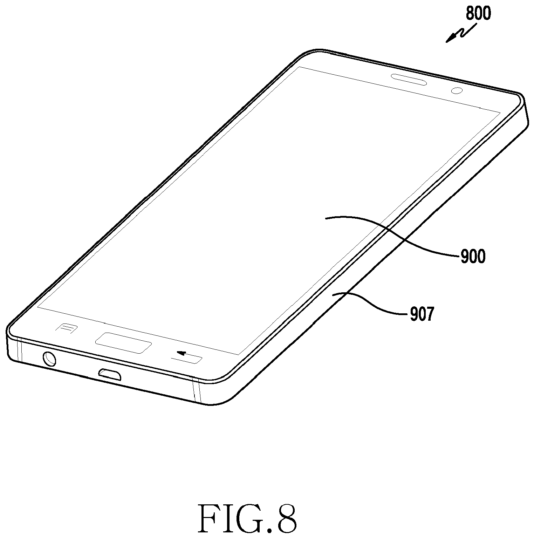

FIG. 8 illustrates an electronic device including a transparent protective layer according to an embodiment of the present disclosure.

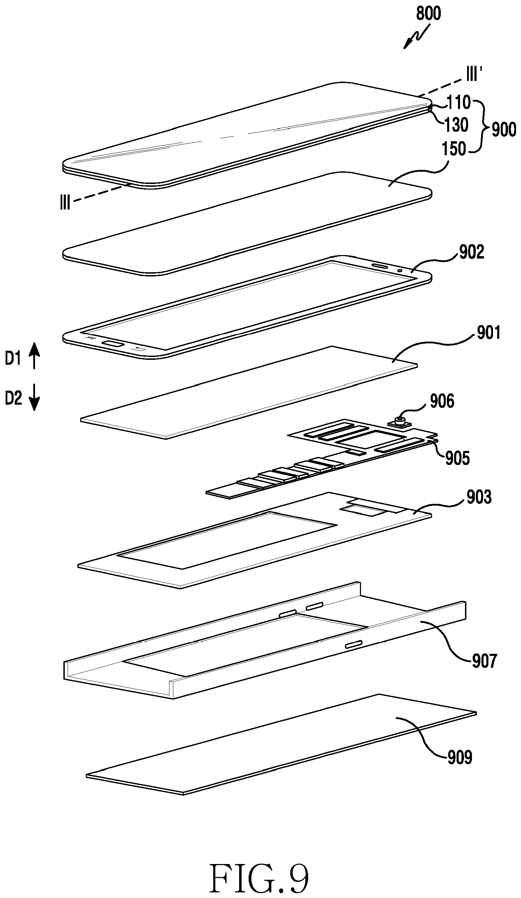

FIG. 9 is an exploded perspective view of the electronic device illustrated in FIG. 8.

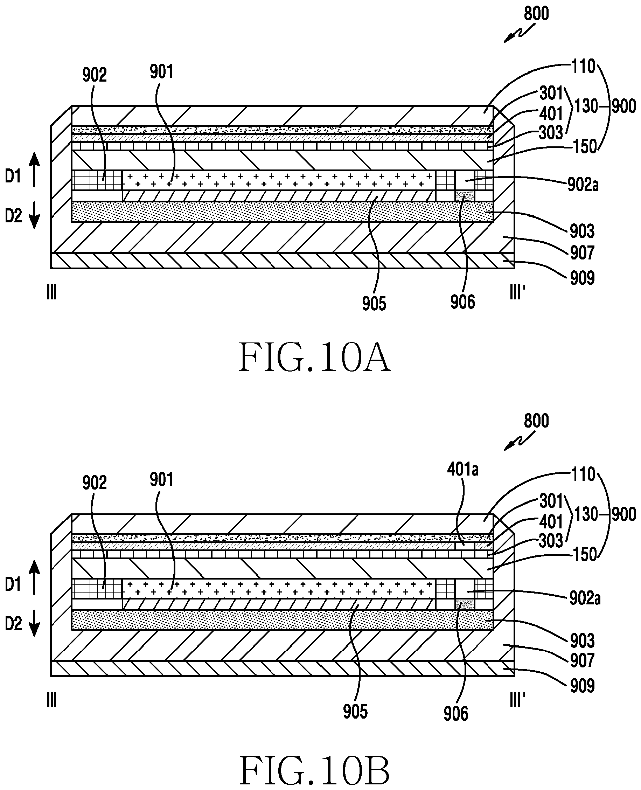

FIGs. 10A and 10B are cross-sectional views taken along line III - III' in FIG. 9 according to various embodiments of the present disclosure.

Referring to FIG. 8, an electronic device 800 may be a smartphone or a mobile phone. However, the present disclosure is not limited thereto, and the electronic device may include a tablet personal computer, a videophone, an e-book reader, a desktop personal computer, a laptop personal computer, a netbook computer, a workstation, a server, a personal digital assistant (PDA), a portable multimedia player (PMP), an MP3 player, a mobile medical device, a camera and a wearable device (e.g., smart glasses, a head-mounted-device (HMD), electronic apparel, an electronic bracelet, an electronic necklace, an electronic appcessory, an electronic tattoo, a smart mirror, or a smart watch).

Alternatively, the electronic device may be a smart home appliance, such as a television, a Digital Video Disk (DVD) player, an audio player, a refrigerator, an air conditioner, a vacuum cleaner, an oven, a microwave oven, a washing machine, an air cleaner, a set-top box, a home automation control panel, a security control panel, a TV box (e.g., Samsung HomeSync^{™}, Apple TV^{™}, or Google TV^{™}), a game console (e.g., Xbox^{™} and PlayStation^{™}), an electronic dictionary, an electronic key, a camcorder, and an electronic photo frame.

The electronic device may also be a medical device (e.g., a portable medical measuring device, such as a blood glucose monitoring device, a heart rate monitoring device, a blood pressure measuring device, a body temperature measuring device, etc., a magnetic resonance angiography (MRA) device, a magnetic resonance imaging (MRI) device, a computed tomography (CT) machine, and an ultrasonic machine), a navigation device, a global positioning system (GPS) receiver, an event data recorder (EDR), a flight data recorder (FDR), a vehicle infotainment device, an electronic device for a ship (e.g., a navigation device and a gyro-compass), avionics, a security device, an automotive head unit, a robot for home or industry, an automatic teller machine (ATM), a point of sales (POS) device, or an Internet of things (IoT) device (e.g., a light bulb, a sensor, an electric or gas meter, a sprinkler device, a fire alarm, a thermostat, a streetlamp, a toaster, sporting goods, a hot water tank, a heater, a boiler, etc.).

The electronic device may also include at least one of a part of furniture or a building/structure, an electronic board, an electronic signature receiving device, a projector, and various kinds of measuring instruments (e.g., a water meter, an electric meter, a gas meter, and a radio wave meter).

The electronic device may also be a flexible device.

The electronic device may also be a combination of the aforementioned devices.

Further, the electronic device is not limited to the aforementioned devices, and may include a new electronic device according to the development of new technology.

As illustrated in FIGs. 8, 9, 10A, and 10B, the electronic device 800 includes a first transparent protective layer 900, a display 901, a decoration film 902, an inner support structure 903, a panel board assembly (PBA) 905, a camera 906, a housing 907, and a second transparent protective layer 909.

The first transparent protective layer 900 is disposed on an outer surface of the electronic device 800. The first transparent protective layer 900 may protect various components disposed thereunder. The first transparent protective layer 900 can prevent a foreign substance from discoloring or penetrating the electronic device 800. The appearance quality of the electronic device 800 can be secured through the first transparent protective layer 900. The first transparent protective layer 900 may transmit internal light generated inside the electronic device 800 to the outside. Further, the first transparent protective layer 900 can transmit external light, which is emitted from the outside of the electronic device 800, to the inside of the electronic device 800.

The first transparent protective layer 900, similar to the transparent protective layer 100 described above, includes a first transparent plate 110, an adhesive layer 130, and a second transparent plate 150. The first transparent plate 110, the adhesive layer 130, and the second transparent plate 150 are sequentially arranged in the second direction D2.

The first transparent plate 110 may form an outer surface of the electronic device 800. The first transparent plate 110 may have a first hardness of pencil hardness 3 H or greater. Through the first transparent plate 110, the electronic device 800 may have improved surface hardness and scratch resistance. The second transparent plate 150 may have a second impact strength, which is greater than that of the first transparent plate 110. The second transparent plate 150 may have a second impact strength of 700 J/m or greater. Through the second transparent plate 150, the electronic device 800 can prevent internal configurations arranged along the second direction D2 from being damaged. In particular, the second transparent plate 150 can prevent breakage of the display 901 due to a partial impact or a drop impact.

The adhesive layer 130 is disposed between the first transparent plate 110 and the second transparent plate 150. The adhesive layer 130 includes a first adhesive layer 301 and a second adhesive layer 303 having different adhesive strengths. The first adhesive layer 301 and the second adhesive layer 303 are sequentially disposed in the second direction D2. The first adhesive layer 301 may have a greater adhesive force than the second adhesive layer 303. For example, an adhesive force of the first adhesive layer 301 may be 500 g/in to 2000 g/in. An adhesive force of the second adhesive layer 303 may be 50 g/in to 300 g/in.

Therefore, when a force is applied to remove the first transparent plate 110, the first transparent plate 110 can be easily separated from the second transparent plate 150 while maintaining adhesion of the first transparent plate 110, the first adhesive layer 301, and the second adhesive layer 303, as described above. Accordingly, when the first transparent plate 110 is damaged by drop impact, breakage or scratching of the electronic device 800, the first transparent plate 110 can be easily replaced.

As illustrated in FIG. 10A, similar to FIG. 4A, the adhesive layer 130 includes the first adhesive layer 301, a third transparent plate 401, and the second adhesive layer 303. That is, the first transparent protective layer 900 may also include the third transparent plate 401 between the first adhesive layer 301 and the second adhesive layer 303.

As described above for FIG. 4A, a laminating process of the first transparent plate 110, the adhesive layer 130, and the second transparent plate 150 may be easily performed through the third transparent plate 401. That is, the adhesive layer 130 may be prepared by forming the first adhesive layer 301 and the second adhesive layer 303 on opposite sides of the third transparent plate 401, and then the transparent protective layer 400A may be produced through a laminating process of the adhesive layer 130 and the first transparent plate 110 and/or the second transparent plate 150. An adhesive force between the first transparent plate 110, the first adhesive layer 301, the third transparent plate 401, and the second adhesive layer 303 may be greater than an adhesive force between the second adhesive layer 303 and the second transparent plate 150. Therefore, the first transparent plate 110, the first adhesive layer 301, the third transparent plate 401, and the second adhesive layer 303 can be easily separated from the second transparent plate 150, while maintaining adhesion of the first transparent plate 110, the first adhesive layer 301, the third transparent plate 401, and the second adhesive layer 303.

The third transparent plate 401 may be made of a transparent material having a high transmittance. The third transparent plate 401 may be made of a material that allows thin-film forming. The third transparent plate 401 may include an isotropic film, e.g., a COP film, a CPP film. The isotropic film may be produced by a non-stretching process or an unstretching process. That is, the third transparent plate 401 may include a non-stretched or unstretched film. A film produced by a non-stretching or unstretching process may have similar tensile strengths in a longitudinal direction and in a transverse direction. Alternatively, tensile elongation in the longitudinal direction and the transverse direction may have similar values to each other. For example, the CPP film may have tensile strength of 80±30 MPa in the longitudinal direction and tensile strength of 60±20 MPa in the transverse direction. In addition, the CPP film may have tensile elongation of 650±300% in the longitudinal direction and 850±300% in the transverse direction. The third transparent plate 401 may include the isotropic film, so that retardation of light that is transmitted through the third transparent plate 401 can be reduced. For example, light that is transmitted through the third transparent plate 401 may have retardation of 10 nm or less. Therefore, the distortion of light can be prevented through the adhesive layer 130 including the isotropic film.

Alternatively, the third transparent plate 401 may include an anisotropic film. The third transparent plate 401 may be, e.g., a PET film or a PP film. The anisotropic film may be a film produced by a stretching process.

Referring to FIG. 10B, the third transparent plate 401 may also include a first opening 401a formed therein. The first opening 401a is disposed at a position corresponding to the camera 906. Therefore, even if the third transparent plate 401 includes the anisotropic film, the distortion of light transmitted through the adhesive layer 130 can be prevented through the first opening 401a, in order to secure the optical performance of the camera 906. The third transparent plate 401 including an isotropic film may also include the opening 401a.

The first transparent protective layer 900 disposed on the front surface of a display 901 may be a transparent window.

The display 901 may be fixed to an inner support structure 903. The display 901 may be fixed to the inner support structure 903 by an adhesive member. The display 901 may be an internal configuration of the electronic device 800 and may perform a substantial operation in the electronic device 800. The display 901 may perform a function of displaying an image.

For example, the display 901 may include a liquid crystal display (LCD), a light-emitting diode (LED) display, an organic light-emitting diode (OLED) display, a microelectromechanical Systems (MEMS) display, or an electronic paper display. The display 901 may display, for example, various types of content (e.g., text, images, videos, icons, symbols, etc.) for a user. The display 901 may include a touch screen that receives a touch, gesture, proximity, and/or hovering input using an electronic pen or a user's body part.

The display 901 may further include a touch panel capable of sensing a touch generated on the surface thereof. For example, the touch panel may sense a touch using at least one of electrostatic, pressure sensitive, infrared, and ultrasonic schemes.

The decoration film 902 may be disposed in an inactive region (e.g., a black matrix (BM) region) of the display 901 on the back surface of the first transparent protective layer 900. The decoration film 902 may be attached to the back surface of the first transparent protective layer 900 through an adhesive layer. The adhesive layer may include OCA. The decoration film 902 may be produced by UV coating after engraving a pattern (e.g., logo) on a PET film. The decoration film 902 may further include a multi-deposited layer and a shielded print layer.

The decoration film 902 may have a color such as white, black, red, blue, yellow, etc. Therefore, the decoration film 902 may form the appearance of the electronic device 800.

As illustrated in FIGs. 10A and 10B, the decoration film 902 includes a second opening 902a. The second opening 902a is formed at a position corresponding to the camera 906 to prevent distortion of light that is incident on the camera 906. That is, the optical performance of the camera 906 can be secured through the second opening 902a.

An inner support structure (e.g., bracket) 903 may support internal configurations of the electronic device 800. The inner support structure 903 may enhance the overall stiffness of the electronic device 800. For example, the inner support structure 903 may include aluminum (Al), magnesium (Mg), and special treatment steel (STS). The inner support structure 903 may include a high-stiffness plastic containing a glass fiber, the internal support structure 903 may include both metal and plastic. When a metal member and a non-metal member are used together to form inner support structure 903, the inner support structure 903 may be formed by insert-injecting a non-metallic member into the metal member. The inner support structure 903 may be disposed on the back surface of the display 901 and has a shape (a curvature) similar to a back surface shape of the display 901.

An elastic member, such as a sponge or a rubber, an adhesive layer, such as a double-sided tape, or a sheet, such as a single-sided tape, may be additionally disposed between the inner support structure 903 and the display 901 to protect the display 901.

The camera 906 photographs still and/or moving images, and may include an image sensor (e.g., a front sensor or a rear sensor), a lens, and an image signal processor (ISP).

The decoration film 902 and the third transparent plate 401 may be disposed in the first direction D1 of the camera 906. The decoration film 902 may include a second opening 902a formed at a position corresponding to the camera 906.

Referring to FIG. 10B, the third transparent plate 401 includes the first opening 401a at a position corresponding to the camera 906. The first opening 401a and the second opening 902a prevent the distortion of light that is transmitted through the first transparent protective layer 900.

The electronic device 800 may further include a sensor. Therefore, the decoration film 902 and the third transparent plate 401 may include openings at a position corresponding to the sensor, thereby securing the performance of the sensor.

The panel board assembly 905 may include a printed circuit board (PCB) and a connector. The panel board assembly 905 may be electrically connected to various configurations including the display 901 and the camera 906.

The housing 907 may fix an internal configuration of the electronic device 800. The housing 907 may be implemented in a form for protecting the internal configuration of the electronic device 800. The housing 907 may include synthetic resins. Alternatively, the housing 907 may include a metal such as stainless steel or titanium (Ti).

The second transparent protective layer 909 may be disposed on the back surface of electronic device 800 to prevent internal configurations of the electronic device 800 from being visible. Alternatively, the second transparent protective layer 909 may form the appearance of the electronic device 800. The second transparent protective layer 909 may have a configuration corresponding to the first transparent protective layer 900 described above.

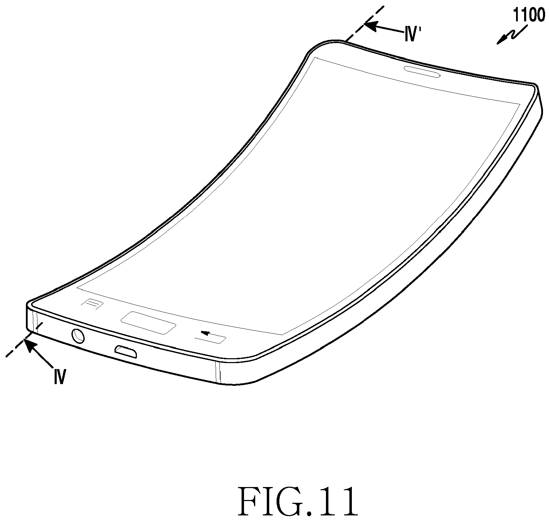

FIG. 11 illustrates an electronic device according to an embodiment of the present disclosure.

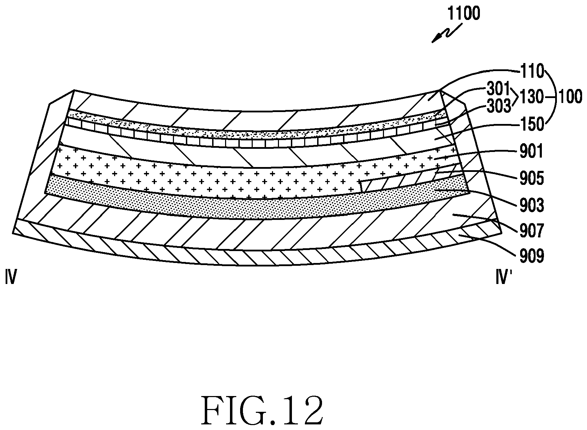

FIG. 12 is a cross-sectional view of the electronic device taken along line IV - IV' in FIG. 11.

Referring to FIGs. 11 and 12, an electronic device 1100 may be a curved electronic device or a flexible electronic device. A transparent protective layer 100 included in the electronic device 1100 may include a curved surface. Alternatively, the transparent protective layer 100 may be flexible. The first transparent protective layer 100 includes a first transparent plate 110, an adhesive layer 130, and a second transparent plate 150. The first transparent protective layer 100 may secure the bending property or feature.

A display 901 included in the electronic device 1100 may include a curved display or flexible display. The display 901 may be in a shape (a shape having a corresponding curvature) corresponding to the transparent protective layer 100. Even if the display 901 is curved or flexible, the transparent protective layer 100 can prevent the display 901 from being pressed or stabbed.

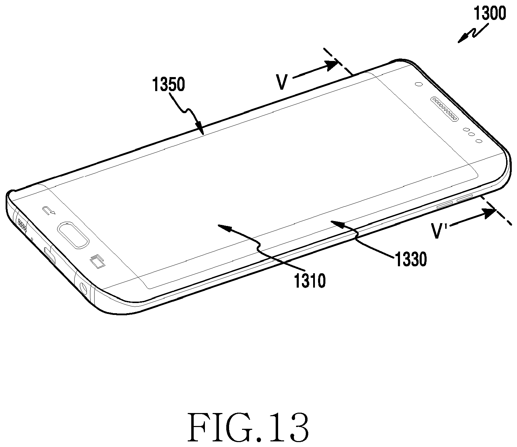

FIG. 13 illustrates an electronic device according to an embodiment of the present disclosure.

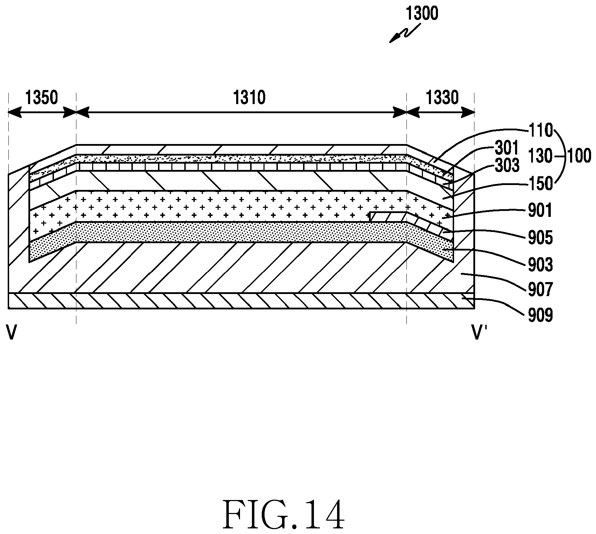

FIG. 14 is a cross-sectional view of the electronic device taken along line V - V' in FIG. 13.

Referring to FIGs. 13 and 14, an electronic device 1300 includes a first surface 1310, a second surface 1330, and a third surface 1350. The first surface 1310 is the front side of the electronic device 1300 and the second surface 1330 and the third surface 1350 are the sides of the electronic device 1300. The second surface 1330 and the third surface 1350 may be bent from the first surface 1310.

The first transparent protective layer 100 included in the electronic device 1300 may be provided to be bent on the second surface 1330 and the third surface 1350.

The display 901 included in the electronic device 1100 may be in a shape (a shape having a corresponding curvature) corresponding to the first transparent protective layer 100. The display 901 may be provided on the first surface 1310 in a plane and may be bent on the second surface 1330 and the third surface 1350.

As described above, an electronic device may include a display; a first transparent plate including a first surface and a second surface facing opposite to the first surface, the first transparent plate being disposed in at least one direction with reference to the display; a second transparent plate including a first surface and a second surface facing opposite to the first surface, the second transparent plate being disposed on the second surface of the first transparent plate; and an adhesive layer disposed between the second surface of the first transparent layer and the first surface of the second transparent plate. The adhesive layer may include a first adhesive layer having a first adhesive force; and a second adhesive layer having a second adhesive force, which is less than the first adhesive force.

The adhesive layer may further include a third transparent plate disposed between the first adhesive layer and the second adhesive layer, and the third transparent plate may be an isotropic film.

The third transparent plate may include CPP.

The third transparent plate may include COP.

The first adhesive force may be 500 g/in to 2000 g/in and the second adhesive force may be50 g/in to 300 g/in.

The first adhesive layer may include at least one of acrylic resin, optically clear adhesive (OCA), optically clear resin (OCR), and urethane resin.

The second adhesive layer may include at least one of silicone resin, PSA, and F.

The first transparent plate or the second transparent plate may include at least one of PC, PMMA, PE, PET, PPT, APET, PEN, PETG, TAC, COP, COC, DCPD, CPD, PAR, PES, PEI, glass, modified epoxy resin, and acrylic resin.

## Claims

1. A transparent protective layer (100; 400A; 400B; 500A; 500B; 800; 1100; 1300), comprising:
a first transparent plate (110) having a first surface (110a) facing in a first direction and a second surface (11 0b) facing in a second direction opposite to the first direction;
a second transparent plate (150) having a first surface (150a) facing in the first direction and a second surface (150b) facing in the second direction; and
an adhesive layer (130) disposed between the second surface (110b) of the first transparent plate (110) and the first surface (150a) of the second transparent plate (150),
wherein the adhesive layer (130) includes a first adhesive layer (301) having a first adhesive force between the first adhesive layer (301) and the first transparent plate (110), and a second adhesive layer (303) having a second adhesive force between the second adhesive layer (303) and the second transparent plate (150), which is less than the first adhesive force, and a third transparent plate (401) disposed between the first adhesive layer (301) and the second adhesive layer (303),
wherein the third transparent plate (401) comprises an opening (401a) formed therein,
wherein the opening (401a) is disposed at a position corresponding to a camera (906).

2. The transparent protective layer (400A; 400B; 500B; 800) of claim 1, wherein the third transparent plate (401) comprises an isotropic film.

3. The transparent protective layer (400A; 400B; 500B; 800) of claim 2, wherein the third transparent plate (401) comprises casting polypropylene, CPP.

4. The transparent protective layer (400A; 400B; 500B; 800) of claim 2, wherein the third transparent plate (401) comprises cyclo olefin polymer, COP.

5. The transparent protective layer (400A; 400B; 500B; 800) of claim 1, wherein the opening (401a) is further disposed at a position corresponding to a sensor.

6. The transparent protective layer (100; 400A; 400B; 500A; 500B; 800; 1100; 1300) of claim 1, wherein the first adhesive layer (301) comprises at least one of acrylic resin, optically clear adhesive (OCA), optically clear resin, OCR, and urethane resin.

7. The transparent protective layer (100; 400A; 400B; 500A; 500B; 800; 1100; 1300) of claim 1, wherein the second adhesive layer (303) comprises at least one of silicone resin, pressure sensitive adhesive (PSA), and fluoride coating layer.

8. The transparent protective layer (100; 400A; 400B; 500A; 500B; 800; 1100; 1300) of claim 1, wherein the first transparent plate (110) has a first Young's modulus, and
wherein the second transparent plate (150) has a second Young's modulus, which is greater than the first Young's modulus.

9. The transparent protective layer (100; 400A; 400B; 500A; 500B; 800; 1100; 1300) of claim 1, wherein the first transparent plate (110) has a first impact strength, and
wherein the second transparent plate (150) has a second impact strength, which is greater than the first impact strength.

10. The transparent protective layer (100; 400A; 400B; 500A; 500B; 800; 1100; 1300) of claim 1, wherein the first transparent plate (110) has a first hardness, and
wherein the second transparent plate (150) has a second hardness, which is less than the first hardness.

11. The transparent protective layer (100; 400A; 400B; 500A; 500B; 800; 1100; 1300) of claim 1, wherein at least one of the first transparent plate (110) and the second transparent plate (150) comprises at least one of:
Polycarbonate, PC;
polymethyl methacrylate, PMMA;
polyimide, PI;
polyethylene terephthalate, PET;
polypropylene terephthalate, PPT;
amorphous polyethylene terephthalate, APET;
polyethylene naphthalate, PEN;
polyethylene terephthalate glycol-modified, PETG;
tri-acetyl cellulose, TAC;
cyclic olefin polymer, COP;
cyclic olefin copolymer, COC;
polydicyclopentadiene, DCPD;
cyclopentadiene anions, CPD;
polyarylate, PAR;
polyether sulfone, PES;
polyether imide, PEI;
glass;
modified epoxy resin; and
acrylic resin.

## Patentansprüche

1. Transparente Schutzschicht (100; 400A; 400B; 500A; 500B; 800; 1100; 1300), die Folgendes umfasst:
eine erste transparente Platte (110) mit einer ersten Oberfläche (110a), die in eine erste Richtung zeigt, und einer zweiten Oberfläche (110b), die in eine zweite Richtung entgegengesetzt zu der ersten Richtung zeigt;
eine zweite transparente Platte (150) mit einer ersten Oberfläche (150a), die in die erste Richtung zeigt, und einer zweiten Oberfläche (150b), die in die zweite Richtung zeigt; und
eine Klebeschicht (130), die zwischen der zweiten Oberfläche (110b) der ersten transparenten Platte (110) und der ersten Oberfläche (150a) der zweiten transparenten Platte (150) angeordnet ist,
wobei die Klebeschicht (130) eine erste Klebeschicht (301) mit einer ersten Klebekraft zwischen der ersten Klebeschicht (301) und der ersten transparenten Platte (110) und eine zweite Klebeschicht (303) mit einer zweiten Klebekraft zwischen der zweiten Klebeschicht (303) und der zweiten transparenten Platte (150), die geringer als die erste Klebekraft ist, und eine dritte transparente Platte (401) enthält, die zwischen der ersten Klebeschicht (301) und der zweiten Klebeschicht (303) angeordnet ist,
wobei die dritte transparente Platte (401) eine darin gebildete Öffnung (401a) umfasst,
wobei die Öffnung (401a) an einer Position angeordnet ist, die einer Kamera (906) entspricht.

2. Transparente Schutzschicht (400A; 400B; 500B; 800) nach Anspruch 1, wobei die dritte transparente Platte (401) einen isotropen Film umfasst.

3. Transparente Schutzschicht (400A; 400B; 500B; 800) nach Anspruch 2, wobei die dritte transparente Platte (401) Gieß-Polypropylen, CPP, umfasst.

4. Transparente Schutzschicht (400A; 400B; 500B; 800) nach Anspruch 2, wobei die dritte transparente Platte (401) zyklisches Olefinpolymer, COP, umfasst.

5. Transparente Schutzschicht (400A; 400B; 500B; 800) nach Anspruch 1, wobei die Öffnung (401 a) ferner an einer Position angeordnet ist, die einem Sensor entspricht.

6. Transparente Schutzschicht (100; 400A; 400B; 500A; 500B; 800; 1100; 1300) nach Anspruch 1, wobei die erste Klebeschicht (301) Acrylharz, optisch klaren Klebstoff (OCA), optisch klares Harz, OCR, und Urethanharz umfasst.

7. Transparente Schutzschicht (100; 400A; 400B; 500A; 500B; 800; 1100; 1300) nach Anspruch 1, wobei die zweite Klebeschicht (303) Silikonharz, druckempfindlichen Klebstoff (PSA) und eine Fluoridbeschichtungsschicht umfasst.

8. Transparente Schutzschicht (100; 400A; 400B; 500A; 500B; 800; 1100; 1300) nach Anspruch 1, wobei die erste transparente Platte (110) einen ersten Elastizitätsmodul aufweist, und
wobei die zweite transparente Platte (150) einen zweiten Elastizitätsmodul aufweist, der größer als der erste Elastizitätsmodul ist.

9. Transparente Schutzschicht (100; 400A; 400B; 500A; 500B; 800; 1100; 1300) nach Anspruch 1, wobei die erste transparente Platte (110) eine erste Schlagzähigkeit aufweist, und
wobei die zweite transparente Platte (150) eine zweite Schlagzähigkeit aufweist, die größer als die erste Schlagzähigkeit ist.

10. Transparente Schutzschicht (100; 400A; 400B; 500A; 500B; 800; 1100; 1300) nach Anspruch 1, wobei die erste transparente Platte (110) eine erste Härte aufweist, und
wobei die zweite transparente Platte (150) eine zweite Härte aufweist, die geringer als die erste Härte ist.

11. Transparente Schutzschicht (100; 400A; 400B; 500A; 500B; 800; 1100; 1300) nach Anspruch 1, wobei die erste transparente Platte (110) und/oder die zweite transparente Platte (150) mindestens eines von Folgendem umfassen:
Polycarbonat, PC;
Polymethylmethacrylat, PMMA,
Polyimid, PI;
Polyethylenterephthalat, PET;
Polypropylenterephthalat, PPT;
amorphes Polyethylenterephthalat, APET;
Polyethylennaphthalat, PEN;
Glykol-modifiziertes Polyethylenterephthalat, PETG;
Triacetylcellulose, TAC;
zyklisches Olefinpolymer, COP;
zyklisches Olefincopolymer, COC;
Polydicyclopentadien, DCPD;
Cyclopentadienanionen, CPD;
Polyarylat, PAR;
Polyethersulfon, PES;
Polyetherimid, PEI;
Glas;
modifiziertes Epoxidharz; und/oder
Acrylharz.

## Revendications

1. Couche de protection transparente (100 ; 400A ; 400B ; 500A ; 500B ; 800 ; 1100 ; 1300), comprenant :
une première plaque transparente (110) ayant une première surface (110a) orientée dans une première direction et une deuxième surface (110b) orientée dans une deuxième direction opposée à la première direction ;
une deuxième plaque transparente (150) ayant une première surface (150a) orientée dans la première direction et une deuxième surface (150b) orientée dans la deuxième direction ; et
une couche adhésive (130) disposée entre la deuxième surface (110b) de la première plaque transparente (110) et la première surface (150a) de la deuxième plaque transparente (150),
où la couche adhésive (130) inclut une première couche adhésive (301) ayant une première force adhésive entre la première couche adhésive (301) et la première plaque transparente (110), et une deuxième couche adhésive (303) ayant une deuxième force adhésive entre la deuxième couche adhésive (303) et la deuxième plaque transparente (150), qui est inférieure à la première force adhésive, et une troisième plaque transparente (401) disposée entre la première couche adhésive (301) et la deuxième couche adhésive (303),
où la troisième plaque transparente (401) comprend une ouverture (401a) formée dans celle-ci,
où l'ouverture (401a) est disposée à une position correspondant à une caméra (906).

2. Couche de protection transparente (400A ; 400B ; 500B ; 800) selon la revendication 1, où la troisième plaque transparente (401) comprend un film isotrope.

3. Couche de protection transparente (400A ; 400B ; 500B ; 800) selon la revendication 2, où la troisième plaque transparente (401) comprend du polypropylène coulé, CPP.

4. Couche de protection transparente (400A ; 400B ; 500B ; 800) selon la revendication 2, où la troisième plaque transparente (401) comprend un polymère d'oléfine cyclique, COP.

5. Couche de protection transparente (400A ; 400B ; 500B ; 800) selon la revendication 1, où l'ouverture (401a) est en outre disposée à une position correspondant à un capteur.

6. Couche de protection transparente (100 ; 400A ; 400B ; 500A ; 500B ; 800 ; 1100 ; 1300) selon la revendication 1, où la première couche adhésive (301) comprend au moins l'un parmi une résine acrylique, un adhésif optiquement transparent (OCA), une résine optiquement transparente, OCR, et une résine uréthane.

7. Couche de protection transparente (100 ; 400A ; 400B ; 500A ; 500B ; 800 ; 1100 ; 1300) selon la revendication 1, où la deuxième couche adhésive (303) comprend au moins une résine de silicone, un adhésif sensible à la pression (PSA), et une couche de revêtement de fluorure.

8. Couche de protection transparente (100 ; 400A ; 400B ; 500A ; 500B ; 800 ; 1100 ; 1300) selon la revendication 1, où la première plaque transparente (110) a un premier module de Young, et
où la deuxième plaque transparente (150) a un deuxième module de Young, qui est supérieur au premier module de Young.

9. Couche de protection transparente (100 ; 400A ; 400B ; 500A ; 500B ; 800 ; 1100 ; 1300) selon la revendication 1, où la première plaque transparente (110) a une première résistance aux chocs, et
où la deuxième plaque transparente (150) a une deuxième résistance aux chocs, qui est supérieure à la première résistance aux chocs.

10. Couche de protection transparente (100 ; 400A ; 400B ; 500A ; 500B ; 800 ; 1100 ; 1300) selon la revendication 1, où la première plaque transparente (110) a une première dureté, et
où la deuxième plaque transparente (150) a une deuxième dureté, qui est inférieure à la première dureté.

11. Couche de protection transparente (100 ; 400A ; 400B ; 500A ; 500B ; 800 ; 1100 ; 1300) selon la revendication 1, où au moins l'une entre la première plaque transparente (110) et la deuxième plaque transparente (150) comprend au moins l'un parmi :
le polycarbonate, PC ;
le polyméthacrylate de méthyle, PMMA,
le polyimide, PI;
le poly(téréphtalate d'éthylène), PET;
le poly(téréphtalate de propylène), PPT;
le poly(téréphtalate d'éthylène) amorphe, APET,
le poly(naphtalate d'éthylène), PEN;
le poly(téréphtalate d'éthylène) modifié par glycol, PETG,
la triacétylcellulose, TAC;
le polymère d'oléfine cyclique, COP;
le copolymère d'oléfine cyclique, COC;
le polydicyclopentadiène, DCPD,
les anions cyclopentadiène, CPD;
le polyarylate, PAR;
la polyéthersulfone, PES;
le polyétherimide, PEI;
le verre;
la résine époxy modifiée; et
la résine acrylique.
